# Europäisches Patentamt

## European Patent Office

## Office européen des brevets

(19)

(11) Veröffentlichungsnummer: **0 246 544**
B1

(12) **EUROPÄISCHE PATENTSCHRIFT**

(45) Veröffentlichungstag der Patentschrift:
05.09.90

(21) Anmeldenummer: **87106870.6**

(22) Anmeldetag: **12.05.87**

(51) Int. Cl.⁵: **H01Q 17/00**, G01R 31/00

(54) Vorrichtung zur EMI-Prüfung elektronischer Geräte.

(30) Priorität: **20.05.86 CH 2026/86**

(43) Veröffentlichungstag der Anmeldung:
**25.11.87 Patentblatt 87/48**

(45) Bekanntmachung des Hinweises auf die Patenterteilung:
**05.09.90 Patentblatt 90/36**

(84) Benannte Vertragsstaaten:
**AT CH DE FR GB LI SE**

(56) Entgegenhaltungen:
**DE-B- 1 276 764**
**GB-A- 2 159 667**

**IEEE TRANSACTIONS ON INSTRUMENTATION AND MEASUREMENT, Band IM-26, Nr. 3, September 1977, Seiten 225-230, New York, US; M.L. CRAWFORD et al.: "Generation of EM susceptibility test fields using a large absorber-loaded TEM cell"**
**PROCEEDINGS OF THE IEEE, Band 73, Nr. 3, März 1985, Seiten 388-411, New York, US; M.T. MA et al.: "A review of electromagnetic compatibility/interference measurement methodologies"**
**PROCEEDINGS OF THE IEEE, Band 66, Nr. 4, April 1978, Seiten 483-507, IEEE, New York, US; W.H. KUMMER et al.: "Antenna measurements - 1978"**

(73) Patentinhaber: **BBC Brown Boveri AG, Haselstrasse, CH-5401 Baden(CH)**

(72) Erfinder: **Hansen, Diethard, Dr., Bahnhofstrasse 39a, CH-8965 Berikon(CH)**
Erfinder: **Königstein, Dietrich, Dr., Pilgerstrasse 18, CH-5405 Dättwil(CH)**

## Beschreibung

### Technisches Gebiet

Die vorliegende Erfindung betrifft eine Vorrichtung zur EMI-Prüfung elektronischer Geräte. "EMI" steht als Abkürzung für "electromagnetic interference". Die Erfindung betrifft insbesondere eine solche Vorrichtung mit einem sich pyramidenförmig aufweitenden TEM-Wellenleiter, welcher durch eine Wand aus Hochfrequenz-Spitzenabsorbern abgeschlossen ist und welcher einen asymmetrisch angeordneten, plattenförmigen Innenleiter aufweist, welcher durch die Absorberwand hindurch auf eine Anzahl von Abschlusswiderständen geführt ist.

### Stand der Technik

Eine Vorrichtung der genannten Art wurde realisiert im Institut für naturwissenschaftlich-technische-Analysen der Frauenhofer Gesellschaft in Euskirchen/BRD. Der TEM-Wellenleiter dieser Vorrichtung ist seitlich offen. Er besteht aus einer unsymmetrischen Drei-Streifenleiter-Anordnung.

Aus Abstrahlungsgründen kann er nur in einer abgeschirmten Halle betrieben werden. Die aus den Hochfrequenz-Spitzenabsorbern aufgebaute Wand steht bei ihm im Leitungsquerschnitt und ist eben. Der Innenleiter ist mit Nylonfäden am oberen Streifenleiter aufgehängt. Im Durchtrittsbereich durch die Absorberwand verjüngt sich der Innenleiter zu den Abschlusswiderständen hin. Dadurch wird eine Kompensation der durch die Absorber verursachten kapazitiven Belastung im Hinblick auf den Wellenwiderstand erreicht. Als Material für den Innenleiter sind sogenannte Leichtstruktur-Aluminium-Platten nach dem Sandwich-Prinzip verwendet. Der TEM-Wellenleiter der Vorrichtung der Frauenhofer-Gesellschaft ist in Längsrichtung nicht zerlegbar. Die mit ihm erreichte Rückflussdämpfung ist bis zu einer Frequenz von etwa 2,5 GHz besser als - 15 dB.

### Darstellung der Erfindung

Es ist Aufgabe der vorliegenden Erfindung eine Vorrichtung der eingangs genannten Art anzugeben, die vor allem im Hinblick auf ihren äusseren Platzbedarf im Verhältnis zum nutzbaren Prüfvolumen verbessert ist. Das Prüfvolumen sollte zumindest einen einzelnen, kleineren Schaltschrank heute gebräuchlicher Grösse aufnehmen können.

Weiter ist es Aufgabe der vorliegenden Erfindung eine Vorrichtung der eingangs genannten Art anzugeben, die bezüglich ihrer Wellenleitungseigenschaften verbessert ist.

Die genannten sowie weitere Aufgaben werden gemäss der vorliegenden Erfindung gelöst durch die Angabe einer neuen Vorrichtung zur EMI-Prüfung elektronischer Geräte mit einem sich pyramidenförmig aufweitenden TEM-Wellenleiter, welcher durch eine Wand aus Hochfrequenz-Spitzenabsorbern abgeschlossen ist und welcher einen asymmetrisch angeordneten, plattenförmigen Innenleiter aufweist, welcher durch die Absorberwand hindurch auf eine Anzahl von Abschlusswiderständen geführt ist; der TEM-Wellenleiter weist weiter einen geschlossenen Aussenleiter auf und die Absorberwand ist nach Art einer Kugelkalotte gekrümmt, wobei der Krümmungsmittelpunkt im Bereich der Spitze des pyramidenförmigen TEM-Wellenleiters liegt.

Durch den geschlossenen Aussenleiter des TEM-Wellenleiters ist die erfindungsgemässe Vorrichtung praktisch frei von Störabstrahlung an die Umgebung. Sie braucht deshalb nicht in einem abgeschirmten Raum betrieben zu werden, sondern kann unmittelbar an jedem beliebigen Ort frei aufgestellt werden. Die äusseren Abmessungen des TEM-Wellenleiters und nicht diejenigen eines abgeschirmten Raumes bestimmen daher den Platzbedarf der Vorrichtung. Das Verhältnis Platzbedarf zu nutzbarem Prüfraumvolumen ist bei der erfindungsgemässen Vorrichtung weitestgehend optimiert.

Durch die Ausbildung der Absorberwand nach Art einer Kugelkalotte werden im TEM-Wellenleiter unterschiedliche Laufwege und Laufzeiten für die elektromagnetischen Wellen vermieden. An sich in einem TEM-Wellenleiter mit geschlossenem Aussenleiter der hier betrachteten Grösse zu erwartende Resonanzprobleme treten nicht auf. Darüber hinaus wird eine ausgezeichnete Feldhomogenität im Prüfvolumen über den gesamten Frequenzbereich erreicht. Gleiches gilt für die Rückflussdämpfung.

Durch die in den abhängigen Patentansprüchen gekennzeichneten Massnahmen können noch weitergehende Verbesserungen erreicht werden.

So ist es von Vorteil, den Innenleiter im Durchtrittsbereich durch die Absorberwand, in der seine Breite zur Kompensation des kapazitiven Einflusses der Absorber auf den Wellenwiderstand reduziert werden muss, in mehrere Teilleiter aufzutrennen und jeweils die Breite der Teilleiter zu den Abschlusswiderständen hin zu verjüngen. Dadurch werden Querkomponenten des Feldes im Abschlussbereich, die Feldverzerrungen und Reflexionen verursachen, auf ein sehr geringes Mass reduziert. Mit einer derart ausgebildeten erfindungsgemässen Vorrichtung von 6,5 m Länge, 1,5 m Bauhöhe und 3 m Breite konnte über einen Frequenzbereich von 0 Hz bis ca. 2,5 GHz eine Rückflussdämpfung von besser als - 20 dB erreicht werden. Für die Homogenität (Schwankungsbreite) des elektromagnetischen Feldes konnte im genannten Frequenzbereich ein Wert von besser als 10 dB ermittelt werden.

Durch eine Ausbildung des TEM-Wellenleiters mit einem abnehmbaren, allseitig gasdichten, überdruckfähigen und mit $SF_6$-Gas füllbaren Speisekeil kann die erfindungsgemässe Vorrichtung auch für extrem hohe Feldstärken geeignet ausgebildet werden. Ergänzend können für diesen Zweck Hochspannungswiderstände als Abschlusswiderstände verwendet werden.

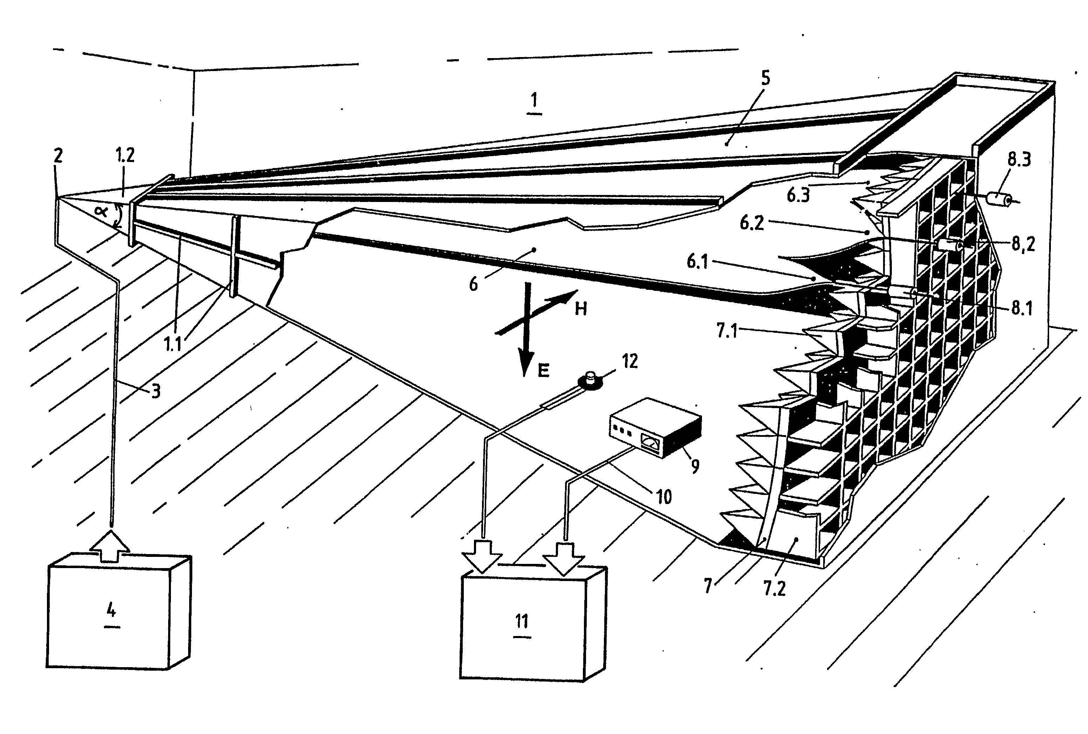

## Kurze Beschreibung der Zeichnung

Weitere Merkmale und Vorteile der vorliegenden Erfindung ergeben sich aus der nachstehenden ausführlichen Beschreibung insbesondere unter Berücksichtigung der beigefügten Zeichnung. Diese zeigt in einer einzigen Figur eine perspektivische Darstellung einer Vorrichtung nach der Erfindung mit einem sich pyramidenförmig aufweitenden TEM-Wellenleiter.

## Bester Weg zur Ausführung der Erfindung

Es wird nunmehr auf die Zeichnung Bezug genommen. In dieser ist mit 1 ein TEM-Wellenleiter bezeichnet. "TEM" steht als Abkürzung für "Transversal-Elektro-Magnetisch". Der TEM-Wellenleiter 1 weitet sich von seiner Spitze 2 aus pyramidenförmig auf. Er weist keine Knickstellen auf. An seiner Spitze 2 ist, in der Zeichnung jedoch nicht erkennbar, eine koaxiale Speisebuchse vorgesehen, über die mittels eines Koaxialkabels 3 ein Impuls- oder Sinusgenerator 4 an den TEM-Wellenleiter 1 anschliessbar ist.

Der TEM-Wellenleiter weist einen geschlossenen Aussenleiter 5 mit rechteckigem Querschnitt auf. Ein plattenförmiger Innenleiter 6 von dreieckiger Form ist in seinem Innern asymmetrisch an Nylonfäden aufgehängt. "Asymmetrisch" bedeutet, dass der Innenleiter 6 zur Oberseite des Aussenleiters 5 einen geringeren Abstand aufweist als zu dessen Unterseite. Durch diese Asymmetrie ergibt sich im unteren Teil des TEM-Wellenleiters 1 ein grösseres nutzbares Prüfvolumen, als wenn der Innenleiter 6 symmetrisch angeordnet wäre. Zudem ergibt sich dadurch eine geringere Rückwirkung der zu prüfenden elektrischen Geräte auf das elektromagnetische Feld. Vorzugsweise beträgt der Abstand des Innenleiters 6 zur Oberseite des Aussenleiters 5 ein Viertel von dessen jeweiliger Höhe. Entsprechend beträgt der Ab stand des Innenleiters 5 zur Unterseite oder Bodenplatte des Aussenleiters 5 drei Viertel von dessen jeweiliger Höhe.

Unter Berücksichtigung der asymmetrischen Anordnung von Innenleiter 6 und Aussenleiter 5 sind deren Breiten im Verhältnis zueinander so gewählt, dass sich für den TEM-Wellenleiter 1 ein dem Impuls- bzw. dem Sinusgenerator 4 und natürlich auch dem Koaxialkabel 3 entsprechender Wellenwiderstand ergibt. Ein Wellenwiderstand von 50 Ohm ergibt sich, bei einem Oeffnungswinkel von 20° und der bevorzugten Asymmetrie von 1/4 : 3/4 etwa durch ein Breitenverhältnis von 0,636.

Wie bereits erwähnt ist der Innenleiter 6 mittels Nylonfäden an der Oberseite des Aussenleiters 5 aufgehängt. Durch eine geringfügige Variation der Länge dieser Nylonfäden und dadurch auch der vorgenannten Asymmetrie ist ein Feinabgleich des Wellenwiderstandes möglich.

Abgeschlossen ist der TEM-Wellenleiter 1 einerseits durch eine Vielzahl von aneinandergrenzenden, in ihrer Gesamtheit einer Absorberwand 7 bildenden pyramidenförmigen Hochfrequenz-Spitzenabsorbern 7.1 sowie andererseits durch drei ohmsche Abschlusswiderstände 8.1, 8.2 und 8.3.

Die Hochfrequenz-Spitzenabsorber 7.1 und die Abschlusswiderstände 8.1, 8.2 und 8.3 ergänzen sich in ihrer Abschlusswirkung. Letztere bilden den wirksamen Abschluss des TEM-Wellenleiters für Frequenzen unterhalb von ca. 100 - 200 MHz. Die Hochfrequenz-Spitzenabsorber sind hinsichtlich ihrer Form und Grösse so ausgebildet, dass sie oberhalb von 100 - 200 MHz zur wirkung kommen.

Die Absorberwand 7 ist nach der Art einer Kugelkalotte gekrümmt. Der Krümmungsmittelpunkt liegt im Bereich der Spitze 2 des TEM-Wellenleiters. Durch diese Krümmung werden unterschiedliche Laufwege und Laufzeiten der elektromagnetischen Wellen im TEM-Wellenleiter 1 vermieden.

Die Spitzenabsorber 7.1 bestehen vorzugsweise aus Polyurethanschaum, welcher mit leitfähigen Partikeln z.B. aus Kohlenstoff in Form von Graphit oder Russ versetzt ist. Trotz dieser Versetzung mit dem leitfähigen Material sind die Absorber 7.1 insgesamt relativ schlechtleitend. Aufgrund ihrer endlichen Leitfähigkeit und ihrer Pyramidenform wird in ihnen HF-Energie in Wärme umgesetzt. Ihre Spitzenhöhe sollte etwa 1/3 der Höhe des Aussenleiters 5 an seinem aufgeweiteten Ende und das Verhältnis von Spitzenhöhe zu Grundfläche etwa 6,5 : 1 betragen. Die Absorberwand 7 bzw. die Spitzenabsorber 7.1 können, wie in der Zeichnung dargestellt, von einem kassettenartigen Gerüst 7.2 gestützt sein. Der Innenleiter 6 ist durch die Absorberwand 7 -zwischen zwei Reihen von Absorbern 7.1 hindurch - unter Aufteilung in drei separate, parallele Teilleiter 6.1, 6.2 und 6.3 auf die Abschlusswiderstände 8.1, 8.2 und 8.3 geführt, wobei an jedem der Teilleiter 6.1, 6.2 und 6.3 ein Abschlusswiderstand angeschlossen ist. Die Abschlusswiderstände 8.1, 8.2 und 8.3 verbinden den Innenleiter bzw. seine Teilleiter 6.1, 6.2 und 6.3 mit dem Aussenleiter 5.

Die Trennstelle des Innenleiters 6 in die Teilleiter 6.1, 6.2 und 6.3 befindet sich etwa auf der Höhe der Spitzen der Absorber 7.1. Die Aufteilung des Innenleiters 6 in die drei Teilleiter 6.1, 6.2 und 6.3 ist so vorgenommen, dass auf jeden der drei Teilleiter bei der Wellenleitung die gleiche Oberflächenladung bzw. der gleiche Teilwellenwiderstand entfällt. Die Abschlusswiderstände 8.1, 8.2 und 8.3 können dann übereinstimmend entsprechend diesen Teilwellenwiderstand bemessen sein. In diesem Fall ist der mittlere Teilleiter 6.2 zunächst breiter als die beiden äusseren 6.1 und 6.3.

Zu den Abschlusswiderständen 8.1, 8.2 und 8.3 hin verlaufen die drei Teilleiter 6.1, 6.2 und 6.3 spitz zu. Dabei ist die Verjüngung ihrer Breite jeweils so vorgenommen, dass der durch die Absorber 7.1 bedingte und durch ihre Spitzen - bzw. Pyramidenform zu den Abschlusswiderständen hin in der Absorberwand 7 zunehmende Kapazitätsbelag in seinem Einfluss auf den Wellenwiderstand bzw. Teilwellenwiderstand grade kompensiert wird.

Der TEM-Wellenleiter 1 kann in Leichtbauweise ausgeführt sein. Als Material für den Aussenleiter können von Aluminiumprofilen 1.1 gestützte Leichtstruktur-Aluminium-Platten nach dem Sandwich-Prinzip verwendet werden. Dieses Material bietet neben geringem Gewicht und hoher Steifigkeit den Vorteil, dass es von der Rolle weg verarbeitet werden kann. Die Seitenteile des Aussenleiters können dadurch aus einem Stück stossfugenfrei ausgebildet sein. Dies ist im Hinblick auf die Vermeidung von Reflexionen von Vorteil. Als Material für den Innenleiter kann ein Aluminiumblech oder ein verzinktes Stahlblech verwendet werden. Auch kann das letzte Drittel der Bodenplatte des Aussenleiters 5 vor der Absorberwand 7, auf dem in der Regel die zu prüfenden elektronischen Geräte, wie das in der Zeichnung dargestellte Gerät 9, zu stehen kommen, durch ein verzinktes Stahlblech verstärkt sein.

Um einen leichten Zugang zum Innern des TEM-Wellenleiters 1 zu schaffen, kann in einer der Seitenwände des Aussenleiters 5 eine Tür vorgesehen sein. Diese Tür ist vorzugsweise eine Schiebetür.

Neben guten Wellenleitungseigenschaften sollte der TEM-Wellenleiter auch ausreichend hochspannungsfest sein, um die Prüfung mit NEMP-Feldstärken von 50 kV/m zu ermöglichen. "NEMP" steht als Abkürzung für den sogenannten "Nuklearen Elektro-Magnetischen Puls". Bei unveränderter Geometrie lässt sich die Hochspannungsfestigkeit des TEM-Wellenleiters 1 wesentlich dadurch steigern, dass er, statt mit Luft, mit einem elektronegativen Gas wie z.B. SF6 unter möglichst hohem Druck gefüllt wird. Bei der bevorzugten Baulänge des TEM-Wellenleiters 1 von über 6 m und der bevorzugten Leichtbauweise ist dies jedoch nicht ohne weiteres möglich. Es ist an sich auch nicht erforderlich, denn Ueberschläge bzw. Durchschläge sind nur im Bereich der Spitze des TEM-Wellenleiters 1 zu erwarten, genauer an der Uebergangsstelle von der im allgemeinen mit einem festen Isolierstoff gefüllten koaxialen Speisebuchse zum gasgefüllten Wellenleiter. Es ist deshalb ausreichend, den Spitzenbereich bzw. den Speisekeil des TEM-Wellenleiters 1 in geeigneter Weise auszubilden. Vorzugsweise wird der Speisekeil des TEM-Wellenleiters 1 als ein gesondertes Teilstück 1.2 ausgebildet, welches am übrigen Teil des TEM-Wellenleiters 1 lösbar befestigt, allseitig gasdicht geschlossen und mit Ueberdruck belastbar ist. Gegenüber dem restlichen Volumen des TEM-Wellenleiters 1 ist das Volumen des abnehmbaren Speisekeils 1.2 mittels einer, die Hochfrequenzeigenschaften möglichst wenig verändernden, dünnen dielektrischen Folie abgedichtet. Die Längsausdehnung des Speisekeils 1.2 braucht nur etwa 1/10 der Gesamtlänge des TEM-Wellenleiters 1 zu betragen.

Im Hinblick auf die Hochspannungsfestigkeit des TEM-Wellenleiters 1 können ergänzend die Abschlusswiderstände als Hochspannungswiderstände ausgebildet sein. Sie sollten für mindestens 100 kV ausgelegt sein. Hochspannungswider-stände sind allerdings naturgemäss lang und weisen aufgrund ihrer Baulänge eine erhebliche Induktivität auf. Dies macht sie für eine Verwendung als Hochfrequenz-Abschlusswiderstände an sich ungeeignet. Hochfrequenz-Abschlusswiderstände sollten möglichst kurz und induktivitätsarm sein. Bei Widerständen schliessen sich gute Hochspannungs- und Hochfrequenzeigenschaften gegenseitig aus. Trotz dieses Problems können bei der erfindungsgemässen Vorrichtung Hochspannungwiderstände verwendet werden, weil sie als Abschlusswiderstände nur bis ca. 100 - 200 MHz benötigt werden und wirksam sein müssen. Oberhalb von 200 MHz wird, wie erläutert, der wirksame Abschluss des TEM-Wellenleiters 1 durch die Hochfrequenz-Spitzenabsorber 7.1 gebildet. Leistungsmässig sollten die Abschlusswiderstände für eine CW-Leistung von bis zu 1 kW ausgelegt sein.

Von dem in den TEM-Wellenleiter 1 verbrachten zu prüfenden elektronischen Gerät, wie dem Gerät 9 in der Zeichnung, führen Messleitungen 10 aus den TEM-Wellenleiter heraus zu geeigneten Messinstrumenten 11. An diese können auch Feldsensoren 12 angeschlossen sein, mit denen die Stärke des elektromagnetischen Feldes im TEM-Wellenleiter 1 in der Nähe des zu prüfenden elektrischen Geräts 9 gemessen wird.

Anstatt zur Prüfung des Einflusses elektromagnetischer Felder auf elektronische Geräte kann die erfindungsgemässe Vorrichtung auch zur Messung der Abstrahlung eines elektronischen Gerätes verwendet werden.

**Patentansprüche**

1. Vorrichtung zur EMI-Prüfung elektronischer Geräte mit einem sich pyramidenförmig aufweitenden TEM-Wellenleiter (1), welcher durch eine Wand (7) aus Hochfrequenz-Spitzenabsorbern (7.1) abgeschlossen ist und welcher einen asymmetrisch angeordneten, plattenförmigen Innenleiter (6) aufweist, welcher durch die Absorberwand (7) hindurch auf eine Anzahl von Abschlusswiderständen (8.1, 8.2, 8.3) geführt ist, dadurch gekennzeichnet, dass der TEM-Wellenleiter (1) einen geschlossenen Aussenleiter (5) aufweist, dass die Absorberwand (7) nach Art einer Kugelkalotte gekrümmt ist und dass der Krümmungsmittelpunkt im Bereich der Spitze (2) des pyramidenförmigen TEM-Wellenleiters (1) liegt.

2. Vorrichtung nach Anspruch 2, dadurch gekennzeichnet, dass der Innenleiter (6) im Durchtrittsbereich durch die Absorberwand (7) in mehrere, vorzugsweise in drei parallele Teilleiter (6.1, 6.2, 6.3) aufgetrennt ist, an die jeweils ein Abschlusswiderstand (8.1, 8.2, 8.3) angeschlossen ist.

3. Vorrichtung nach Anspruch 2, dadurch gekennzeichnet, dass der Innenleiter (6) derart in die Teilleiter (6.1, 6.2, 6.3) aufgetrennt ist, dass auf jeden der Teilleiter bei der Wellenleitung die gleiche Oberflächenladung bzw. der gleiche Teilwellenwiderstand entfällt.

4. Vorrichtung nach Anspruch 7, dadurch gekennzeichnet, dass an die Teilleiter (6.1, 6.2, 6.3) gleich grosse Abschlusswiderstände (8.1, 8.2, 8.3) angeschlossen sind.

5. Vorrichtung nach Anspruch 2, dadurch gekennzeichnet, dass die Teilleiter (6.1, 6.2, 6.3) zu den Abschlusswiderständen (8.1, 8.2, 8.3) hin spitz zulaufen und dass die Verjüngung ihrer Breite derart vorgenommen ist, dass der in der Absorberwand (7) zu den Abschlusswiderständen hin zunehmende Kapazitätsbelag in seiner Auswirkung auf den Wellenwiderstand bzw. Teilwellenwiderstand gerade kompensiert wird.

6. Vorrichtung nach Anspruch 1, dadurch gekennzeichnet, dass der TEM-Wellenleiter (1) einen abnehmbaren Speisekeil (1.2) aufweist, dessen Längsausdehnung etwa ein Zehntel der Gesamtlänge des TEM-Wellenleiters (1) entspricht.

7. Vorrichtung nach Anspruch 6, dadurch gekennzeichnet, dass der abnehmbare Speisekeil (1.2) allseitig, gegenüber dem übrigen Teil des TEM-Wellenleiters (1) insbesondere mittels einer dielektrischen Folie, gasdicht abgeschlossen und vorzugsweise sogar zur Aufnahme eines Ueberdruckes ausgebildet ist.

8. Vorrichtung nach Anspruch 7, dadurch gekennzeichnet, dass das Volumen des abnehmbaren Speisekeils (1.2) des TEM-Wellenleiters (1) mit $SF_6$-Gas, vorzugsweise unter Ueberdruck, gefüllt ist.

9. Vorrichtung nach Anspruch 1, dadurch gekennzeichnet, dass die Abschlusswiderstände (8.1, 8.2, 8.3) als Hochspannungswiderstände für mindestens 100 kV ausgebildet sind.

## Claims

1. Device for the EMI testing of electronic systems having a TEM waveguide (I), which opens out in a pyramid shape and which is terminated by a wall (7) of highfrequency peak absorbers (7.1) and which exhibits an asymmetrically disposed, plate-shaped inner line (6), which is connected to a number of terminal resistors (8.1, 8.2, 8.3) through the absorber wall (7), characterized in that the TEM waveguide (1) exhibits a closed outer line (5), in that the absorber wall (7) is curved in the manner of a spherical segment, and in that the centre of curvature is situated in the region of the tip (2) of the pyramid-shaped TEM waveguide (1).

2. Device according to Claim 1, characterized in that the inner line (6) is separated, in the region of passage through the absorber wall (7), into a plurality, preferably into three parallel partial lines (6.1, 6.2, 6.3), to which respective terminal resistors (8.1, 8.2, 8.3) are connected.

3. Device according to Claim 2, characterized in that the inner line (6) is divided into the partial lines (6.1, 6.2, 6.3) in such a manner that the same surface charge or the same partial characteristic impedance is allocated to each one of the partial lines in the course of wave propagation.

4. Device according to Claim 2, characterized in that equally large terminal resistors (8.1, 8.2, 8.3) are connected to the partial lines (6.1, 6.2, 6.3).

5. Device according to Claim 2, characterized in that partial lines (6.1, 6.2, 6.3) taper acutely towards the terminal resistors (8.1, 8.2, 8.3), and in that the taper of their width is provided in such a manner that the capacitive covering, which increases in the absorber wall (7) towards the terminal resistors, is just compensated in its effect on the characteristic impedance or partial characteristic impedance.

6. Device according to Claim 1, characterized in that the TEM waveguide (1) exhibits a removable feed wedge (1.2), the longitudinal extent of which corresponds approximately to one tenth of the total length of the TEM waveguide (1).

7. Device according to Claim 6, characterized in that the removable feed wedge (1.2) is sealed in a gastight manner on all sides, in relation to the remaining part of the TEM waveguide (1), in particular by means of a dielectric foil, and is preferably constructed even to accommodate an excess pressure.

8. Device according to Claim 7, characterized in that the volume of the removable feed wedge (1.2) of the TEM waveguide (1) is filled with $SF_6$ gas, preferably under excess pressure.

9. Device according to Claim 1, characterized in that terminal resistors (8.1, 8.2, 8.3) are constructed as high-tension resistors for at least 100 kV.

## Revendications

1. Dispositif pour la vérification de l'IEM d'appareils électroniques à l'aide d'un guide d'ondes TEM (1) s'élargissant en pyramide, qui est terminé par une paroi faite d'absorbeurs de crêtes de haute fréquence (7.1) et qui présente un conducteur interne en forme de plaque (6) à disposition asymétrique qui est amené à travers la paroi d'absorbeur (7) à un certain nombre de résistances de terminaison (8.1, 8.2, 8.3), caractérisé en ce que le guide d'ondes TEN (1) présente un conducteur externe (5) fermé, la paroi d'absorbeurs (7) est courbée en calotte sphérique et le centre de courbure est situé dans la région du sommet (2) du guide d'ondes TEM (1) de forme pyramidale.

2. Dispositif suivant la revendication 1, caractérisé en ce que dans la zone où il traverse la paroi d'absorbeurs (7), le conducteur interne (6) est divisé en plusieurs, de préférence en trois, conducteurs partiels parallèles (6.1, 6.2, 6.3) auxquels est chaque fois connectée une résistance de terminaison (8.1, 8.2, 8.3).

3. Dispositif suivant la revendication 3, caractérisé en ce que le conducteur interne (6) est divisé en conducteurs partiels (6.1, 6.2, 6.3) d'une manière telle que chaque conducteur partiel reçoive, lorsqu'il est en fonction comme guide d'ondes, la même charge superficielle ou la même impédance caractéristique partielle.

4. Dispositif suivant la revendication 2, caractérisé en ce que des résistances de terminaison (8.1, 8.2, 8.3) de mêmes dimensions sont connectées aux conducteurs partiels (6.1, 6.2, 6.3).

5. Dispositif suivant la revendication 2, caractérisé en ce que les conducteurs partiels (6.1, 6.2, 6.3) s'étendent en pointe en direction des résistances de terminaison (8.1, 8.2, 8.3) et la diminution de leur largeur est réalisée d'une manière telle que l'effet sur l'impédance caractéristique ou l'impédance caractéristique partielle de la charge capacitive augmentant dans la paroi d'absorbeur (7) en direction des résistances de terminaison soit exactement compensé.

6. Dispositif suivant la revendication 1, caractérisé en ce que le guide d'ondes TEM (1) comporte un coin d'alimentation amovible (1.2), dont l'étendue longitudinale correspond à peu près à 1/10 de la longueur totale du guide d'ondes TEM (1).

7. Dispositif suivant la revendication 6, caractérisé en ce que le coin d'alimentation amovible (1.2)

9 EP 0 246 544 B1

est fermé de toute part de manière étanche au gaz à l'égard du reste du guide d'ondes TEM (1), en particulier au moyen d'une pellicule diélectrique et est, de préférence, même conçu pour supporter une surpression.

8. Dispositif suivant la revendication 7, caractérisé en ce que le volume du coin d'alimentation amovible (1.2) du guide d'ondes TEM (1) est rempli de $SF_6$ gazeux, de préférence sous pression.

9. Dispositif suivant la revendication 1, caractérisé en ce que les résistances de terminaison (8.1, 8.2, 8.3) ont la forme de résistances haute tension conçues pour au moins 100 kV.